# EUROPEAN PATENT SPECIFICATION

(11) **EP 4 450 993 B1**
(45) Date of publication and mention of the grant of the patent: **18.02.2026**
(21) Application number: 23169022.3
(22) Date of filing: 20.04.2023
(51) Int. Cl.: G01R 33/032, C09K 19/12

(54) **AN ELECTRIC POWER SOURCE-FREE MICROSENSOR FOR DETECTING HIGH-FREQUENCY ALTERNATING MAGNETIC FIELDS**
MIKROSENSOR OHNE ELEKTRISCHE ENERGIEQUELLE ZUR DETEKTION HOCHFREQUENTER WECHSELMAGNETFELDER
MICROCAPTEUR SANS SOURCE D'ÉNERGIE ÉLECTRIQUE POUR DÉTECTER DES CHAMPS MAGNÉTIQUES ALTERNATIFS HAUTE FRÉQUENCE

(43) Date of publication of application: 23.10.2024
(73) Proprietor: KIST-Europe Forschungsgesellschaft mbH, 66123 Saarbrücken (DE)
(72) Inventor: Sung, Baeckkyoung, Saarbrücken (DE); Mohizin, Abdul, Saarbrücken (DE)
(74) Representative: Schön, Christoph

(56) References cited:
- JP-A- 2011 220 957
- SU-A1- 1 241 167
- AKAGI K ET AL: "ORIENTATIONAL BEHAVIOR OF NEMATIC LIQUID CRYSTALS CONTAINING A SOLUBLE ZIEGLER-NATTA CATALYST UNDER MAGNETIC FIELD", MOLECULAR CRYSTALS AND LIQUID CRYSTALS(INC. NONLINEAR OPTICS ), GORDON AND BREACH SCIENCE PUBLISHERS, READING, GB, vol. 172, 1 July 1989 (1989-07-01), pages 115 - 123, XP000050354
- TILEN POTISK ET AL: "Magneto-optic dynamics in a ferromagnetic nematic liquid crystal", ARXIV.ORG, CORNELL UNIVERSITY LIBRARY, 201 OLIN LIBRARY CORNELL UNIVERSITY ITHACA, NY 14853, 13 March 2018 (2018-03-13), XP080864233, DOI: 10.1103/PHYSREVE.97.012701

## Description

### TECHNICAL FIELD OF THE INVENTION

The present invention relates to a sensor for detecting high-frequency alternating magnetic fields which operates without any external electric power source, a method for detecting high-frequency alternating magnetic fields and the use of said sensor in detecting high-frequency alternating magnetic fields.

### BACKGROUND ART OF THE INVENTION

For a detection of static magnetic fields, sensors comprising liquid crystals are widely known. For example JP 2011-220957 A1 describes a static magnetic field measuring device comprising a liquid crystal panel which comprises a layer of liquid crystals the orientation of which varies with an applied voltage, wherein the liquid crystals rotate a plane of polarization of a probe light passing through a cell in a period of time in which no voltage is applied to the liquid crystals, and wherein the liquid crystals do not rotate the plane of polarization of the probe light in a period of time in which a voltage is applied to the liquid crystal. SU 1241167 A1 discloses another static magnetic field measuring device comprising a liquid crystal matrix and employing inductive heating.

However, such devices are only capable of detecting static magnetic fields and require an external electric power source.

Furthermore, in the respective field of the art also sensors are known which can detect high-frequency alternating magnetic fields (HF-AMFs). In general, current magnetic field sensing technology is predominantly based on solid-state systems, such as semiconductors, magnetic metals, and superconducting multilayers, which operate on the basis of sophisticated electronics by using an electric power supply. For example, a solid-state system-based sensor for the detection of high-frequency alternating magnetic fields is described by A. Asfour et al., "High frequency amplitude detector for GMI magnetic sensors", Sensors 14, 24502-24522, 2014.

HF-AMFs are well known to be an environmental risk factor that may adversely affect both the health of human beings and the ecosystem. For example, long-term exposure to radiofrequency AMFs has shown to induce brain damage, neuromuscular disorder, and miscarriage. As the recent progress in mobile communications and networking requires more localized and stronger field intensities at high frequency range, there is an increasing demand for a simple and wearable detection technique for HF-AMFs, which is energy saving and ubiquitously applicable in everyday life.

However, even though the above-described sensors for HF-AMFs can precisely measure the magnetic field amplitude, said sensors indispensably require complex control mechanisms which hamper miniaturization, mechanical flexibility, and/or adaptation to wearable devices. Furthermore, intensive HF-AMFs may potentially interfere with the sensor-associated electronic architectures and microprocessors embedded in the sensor device.

To sum up, current HF-AMF sensors are significantly limited with respect to structural simplification, adaptation to mobile technology, and low-power consumption.

Therefore, an object of the present invention is to provide a sensor for detecting high-frequency alternating magnetic fields, which operates without an electric power source and is easily susceptible to miniaturization, has a high mechanical flexibility and is capable for use on wearable devices.

### SUMMARY OF THE INVENTION

The present invention provides an electric power source-free sensor for detecting high-frequency alternating magnetic fields comprising a chip which comprises (1) a matrix of thermosensitive liquid crystals which exhibit nematic-isotropic phase transition, and (2) a grid of ferromagnetic wires in thermal contact with the matrix of the thermosensitive liquid crystals, said sensor further comprising polarizing films which are aligned in an angle of 60° to 120° to each other (crossed polarizing films) and which are arranged on a first surface and on a second surface of the chip so as to sandwich the chip.

The present invention further provides a method of detecting high-frequency alternating magnetic fields, comprising a step of detecting a high-frequency alternating magnetic field by using an electric power source-free sensor, said sensor comprising a chip which comprises (1) a matrix of thermosensitive liquid crystals which exhibit nematic-isotropic phase transition, and (2) a grid of ferromagnetic wires in thermal contact with the matrix of the thermosensitive liquid crystals, said sensor further comprising polarizing films which are aligned in an angle of 60° to 120° to each other (crossed polarizing films) and which are arranged on a first surface and on a second surface of the chip so as to sandwich the chip, wherein said step of detecting comprises a phase transition of said thermosensitive liquid crystals from a nematic phase to an isotropic phase in the presence of a high-frequency alternating magnetic field.

Furthermore, the present invention provides use of a sensor comprising a chip which comprises (1) a matrix of thermosensitive liquid crystals which exhibit nematic-isotropic phase transition, and (2) a grid of ferromagnetic wires in thermal contact with the matrix of the thermosensitive liquid crystals, said sensor further comprising polarizing films which are aligned in an angle of 60° to 120° to each other (crossed polarizing films) and which are arranged on a first surface and on a second surface of the chip so as to sandwich the chip, wherein said sensor is not connected to any electrical power source.

### BRIEF DESCRIPTION OF FIGURES

Fig.1 illustrates an electric power source-free sensor for detecting high-frequency alternating magnetic fields of the present invention.
Fig. 2 shows an exemplary embodiment of the electric power source-free sensor of the present invention in presence of a magnetic field generator coil.
Fig.3 illustrates images of the exemplary electric power source-free sensor of the Example over a lapse of time before, during and after an application of a high-frequency alternating magnetic field.

### DETAILED DESCRIPTION OF THE INVENTION

The present invention provides an electric power source-free sensor for detecting high-frequency alternating magnetic fields comprising a chip which comprises (1) a matrix of thermosensitive liquid crystals which exhibit nematic-isotropic phase transition, and (2) a grid of ferromagnetic wires in thermal contact with the matrix of the thermosensitive liquid crystals, said sensor further comprising polarizing films which are aligned in an angle of 60° to 120° to each other (crossed polarizing films) and which are arranged on a first surface and on a second surface of the chip so as to sandwich the chip.

In general, a "high-frequency alternating magnetic field (HF-AMF)" in the context of the present invention is a high-frequency alternating magnetic field with a frequency range which is in the radiofrequency range, wherein the frequency range is between 100 kHz to 300 GHz. Typically, the intensity of such HF-AMFs is 5 kA/m or more.

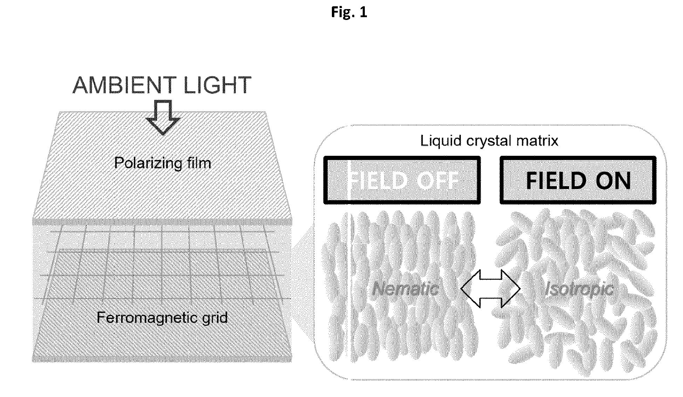

The structure of a sensor according to the present invention is illustrated in Figure 1. When an external HF-AMF is brought into proximity of the sensor comprising a chip which comprises (1) a matrix of thermosensitive liquid crystals which exhibit nematic-isotropic phase transition, and (2) a grid of ferromagnetic wires, said sensor physically interacts with the HF-AMF via magnetothermal effects such as magnetic induction heating. As a result, the grid of ferromagnetic wires generates heat when the sensor is in proximity to the HF-AMF.

Due to the heat generated the local temperature within the chip increases. As a result thereof, when the temperature exceeds the nematic-isotropic phase-transition temperature (T_{N-I}) of the thermosensitive liquid crystals (LCs), the LCs undergo a phase transition from a nematic phase, which is a quasi-1D ordered state of the LCs, to an isotropic phase, which is a 3-dimensionally disordered state of the LCs.

Usually, a response time for the LCs to undergo a phase transition when the T_{N-I} is exceeded, depends on the several factors such as the thermosensitive LCs, the density thereof, the grid structure and so on, but the response time usually falls within a range between 0.1 ms to 20 s, preferably within a range of 1 ms to 10 s, and more preferably within a range of 10 ms to 5 s. If the response time for the phase transition when the T_{N-I} is exceeded is longer than 20 s, the LCs of the sensor and/or the grid structure and/or the concentration of the LCs may be changed so as to provide a sensor having a response time to a HF-AMF which falls within the above-mentioned ranges.

As outlined above, when the LCs undergo a nematic-isotropic phase transition, the light transmittance through the sensor changes. In other words, whereas the sensor comprising the LCs exhibiting a nematic phase show a high light transmittance with strong birefringence, when brought into proximity with a HF-AMF the LCs undergo a phase transition into an isotropic phase when the T_{N-I} is exceeded, so that the sensor comprising the LCs exhibiting an isotropic phase shows a near-zero transmittance. This phase transition does not require presence of an external electric power source and is entirely reversible so that in the absence of a HF-AMF the liquid crystals will undergo a phase transition from isotropic phase to nematic phase by heat dissipation.

An "electric power source" in the context of the present invention is any power supplying device which is connected to the sensor and supplies electric power to the sensor according to the present invention, such as a battery, a power generator, a cable-based power supply and the like.

In general, for the LC material of the LC matrix of the present invention any thermotropic LC compounds, which exhibit nematic-isotropic phase transition can be used. In a preferred embodiment the thermosensitive LCs exhibit nematic-isotropic phase transition in a temperature range between 0°C and 80°C, 10°C to 70°C, 15°C to 65°C, or 20°C to 60°C. In a more preferred embodiment, the thermosensitive LCs exhibit nematic-isotropic phase transition in a temperature range between 25°C and 55°C, even more preferably between 30 °C and 50 °C. In general, depending on the intended application temperature range of the sensor according to the present invention, an LC material exhibiting a nematic-isotropic phase transition with the intended application temperature range to be selected, should be used, i.e. a lower T_{N-I} of the LCs may allow applications at low temperatures for example for aeronautics or space technology applications, whereas a higher T_{N-I} may allow use of the sensor according to the present invention at elevated temperatures.

Preferably, if the sensor according to the present invention should be used at ambient temperatures, the thermosensitive LC material may comprise one or more LC compounds selected from the group consisting of 4-cyano-4'-pentylbiphenyl (5CB, T_{N-I} = 35 °C), N-(p-methoxybenzylidene)-p'-n-butylaniline (MBBA; T_{N-I} = 47 °C) and p-pentylphenyl-trans-p'-pentylcyclohexylcarboxylate (T_{N-I} = 47 °C). In an even more preferred embodiment, the thermosensitive LC material comprises 4-cyano-4'-pentylbiphenyl.

It is also known in the art, that LC compounds can be chemically modified so as to increase or decrease the respective T_{N-I} of the LC compound depending on the substituents which are chemically introduced.

With respect to the grid of ferromagnetic wire material to be used for the sensor according to the present invention, any ferromagnetic wire material can be used which physically responds to a HF-AMF via magnetothermal effects such as magnetic induction heating.

In a preferred embodiment the ferromagnetic wire material can be formed of one or more ferromagnetic materials selected from the group consisting of nickel, iron and cobalt and alloys thereof. In a more preferred embodiment, the ferromagnetic wire material is formed of ferromagnetic nickel alloy material.

Furthermore, in a preferred embodiment, the ferromagnetic wire material may have a wire diameter of 10 to 200 µm, more preferably 20 to 100 µm, and even more preferably 40 to 60 µm. As well known to a person skilled in the art, by increasing the wire diameter the heat generation efficiency of a ferromagnetic wire material is also increasing. If the wire diameter is less than 10 µm, the heat generation efficiency due to the magnetothermal effects may not be sufficient for use in a sensor according to the present invention. If the wire diameter is more than 200 µm, the sensor may not have sufficient high mechanical flexibility.

According to the present invention, the wires of the ferromagnetic material may be formed into a grid having an appropriate grid hole size (mesh size). The term "grid hole size (mesh size)" means an average distance between two adjacent ferromagnetic wires in a grid formed (not including the thickness of the wires themselves). As well known to a person skilled in the art, provided that the wire diameter of a ferromagnetic wire material remains constant, the smaller the grid hole size is, the faster heat transfer from the ferromagnetic wire material to the LC material will occur. For example, according to the present invention a wire material having a wire hole size of 10 to 200 µm is used to form a grid having hole sizes in a range of from 50 to 600 µm, preferably 100 to 400 µm, or more preferably 200 to 300 µm.

Furthermore, in a preferred embodiment the ferromagnetic wire material may be coated with a coating material. By coating the ferromagnetic wire material an alignment of the LC molecules in the LC matrix can be improved. However, coating of the ferromagnetic wire material does not have an influence on the sensing efficiency of the sensor, but gives rise to an improved mechanical and structural stability of the sensor according to the present invention.

In a preferred embodiment, the ferromagnetic wire material may be coated with hexadecyltrimethylammonium bromide (CTAB).

According to the present invention in the sensor as defined above, the grid of ferromagnetic wire material is in thermal contact with the matrix of thermosensitive LCs. When the sensor according to the present invention is brought into proximity of a HF-AMF, the grid of ferromagnetic wire material generates heat due to magnetothermal effects such as magnetic induction heating.

In a preferred embodiment, the grid of ferromagnetic wire material is embedded in the matrix of thermosensitive LCs. When the grid of ferromagnetic wire material is embedded in the matrix of thermosensitive LCs, heat generated by magnetothermal effects such as magnetic induction heating can be transferred in an efficient manner to the matrix of thermosensitive LCs.

Furthermore, in order to ensure an efficient heat transfer from the grid of ferromagnetic wire material to the matrix of thermosensitive LCs, two or more layers of a matrix of thermosensitive LCs into which a grid of ferromagnetic wire material is embedded, wherein the matrices of thermosensitive LCs and/or the grids of ferromagnetic wire materials may be the same or different, may be stacked on top of each other.

With respect to the polarizing films (linear polarizing films) used according to the present invention, in order to provide a good visibility of the phase transition of the thermosensitive LC material present in the sensor according to the present invention, said polarizing films are aligned in an angle of 60° to 120° to each other (crossed polarizing films) and are arranged on a first surface and on a second surface of the sensor chip (comprising (1) the thermosensitive LC material and (2) the grid of ferromagnetic wire material) so as to sandwich the chip.

In a preferred embodiment, the polarizing films are aligned in an angle of 65° to 115° to each other, more preferably 75° to 105° to each other, or even more preferably 85° to 95° to each other (crossed polarizing films). When the polarizing films are arranged so that their direction of polarization is twisted against each other, a visual signal output is created by the sensor when a HF-AMF is detected by the sensor. However, the intensity of the visual signal output of the sensor increases the closer the angle in which the polarizing films are aligned with respect to each other, converges an angle of 90°.

In a preferred embodiment, the polarizing films are highly flexible polymeric polarizing films having a thickness of between 0.05 and 1 mm, preferably of between 0.15 to 0.80 mm, more preferably of between 0.3 to 0.7 mm. If flexible polymeric polarizing films having a thickness of between 0.05 and 1 mm are used, the mechanical flexibility of the sensor according to the present invention may be improved.

In a preferred embodiment, the polarizing films are made from (i) polyvinyl alcohol (PVA) optionally containing dichroic iodine complexes, or (ii) ultra-high-molecular-weight poly(ethylene) (UHMWPE).

In another aspect of the present invention, a method of detecting high-frequency alternating magnetic fields (HF-AMFs) is provided, said method comprising a step of detecting a high-frequency alternating magnetic field by using an electric power source-free sensor, said sensor comprising a chip which comprises (1) a matrix of thermosensitive liquid crystals which exhibit nematic-isotropic phase transition, and (2) a grid of ferromagnetic wires in thermal contact with the matrix of the thermosensitive liquid crystals, said sensor further comprising polarizing films which are aligned in an angle of 60° to 120° to each other (crossed polarizing films) and which are arranged on a first surface and on a second surface of the chip so as to sandwich the chip, wherein said step of detecting comprises a phase transition of said thermosensitive liquid crystals from a nematic phase to an isotropic phase in the presence of a high-frequency alternating magnetic field, wherein said sensor is not connected to any electrical power source.

In a preferred embodiment of the method of detecting HF-AMFs, the matrix of thermosensitive liquid crystals (LCs) comprises one or more LC compounds selected from the group consisting of 4-cyano-4'-pentylbiphenyl (5CB, T_{N-I} = 35 °C), N-(p-methoxybenzylidene)-p'-n-butylaniline (MBBA; T_{N-I} = 47 °C) and p-pentylphenyl-trans-p'-pentylcyclohexylcarboxylate (T_{N-I} = 47 °C). In a more preferred embodiment, the thermosensitive LC material comprises 4-cyano-4'-pentylbiphenyl.

In a further preferred embodiment of the method of detecting HF-AMFs, the grid of the sensor used for detecting HF-AMFs comprises a grid of ferromagnetic wires having a wire diameter of 10 to 200 µm, more preferably 20 to 100 µm, and even more preferably 40 to 60 µm.

In a further preferred embodiment of the above-mentioned method, the step of detecting a high-frequency alternating magnetic field comprises a step of bringing the sensor according to the present invention into such a proximity of a HF-AMF so that a distance between the sensor and the HF-AMF is 1 m or less.

In a further aspect of the present invention, a use of a sensor for detecting a high-frequency alternating magnetic field is provided, wherein said sensor comprises a chip which comprises (1) a matrix of thermosensitive liquid crystals which exhibit nematic-isotropic phase transition, and (2) a grid of ferromagnetic wires in thermal contact with the matrix of the thermosensitive liquid crystals, said sensor further comprising polarizing films which are aligned in an angle of 60° to 120° to each other (crossed polarizing films) and which are arranged on a first surface and on a second surface of the chip so as to sandwich the chip, wherein said sensor is not connected to any electrical power source.

### Example

The following example should not limit the disclosure of the present application and is only provided as additional explanation how to carry out the present invention.

In more detail, in the following example a sensor was fabricated, said sensor comprising a chip which comprises (1) a matrix of thermosensitive liquid crystals which exhibit nematic-isotropic phase transition, and (2) a grid of ferromagnetic wires in thermal contact with the matrix of the thermosensitive liquid crystals, wherein said chip has a length of approximately 1 cm and a width of approximately 1 cm. The liquid crystals used are formed of 4-cyano-4'-pentylbiphenyl and the ferromagnetic wires are formed of a nickel alloy coated with hexadecyltrimethylammonium bromide, having a wire diameter of 50 µm and a grid hole size (mesh size) of 300 µm. In the sensor of this example the grid of ferromagnetic wires was embedded in the matrix of liquid crystals. The total thickness of the chip comprising the matrix of liquid crystal and the grid ferromagnetic wires was approximately 100 µm. Plates made of polarizing films were attached to the top and bottom surfaces of the chip. As polarizing films highly flexible linear polymeric polarizing films having an average thickness of between 0.1 and 0.5 mm were used.

Thereafter, a high-frequency alternating magnetic field with a frequency of 21 kHz and a field strength of 90 mT was generated by a magnetic field generator coil and brought into a proximity of 0.1 m to the fabricated sensor chip.

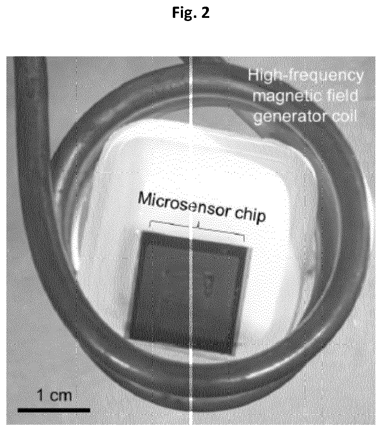

A general experimental setup is shown in Figure 2. After 5 s, the high-frequency alternating magnetic field generator coil was switched off.

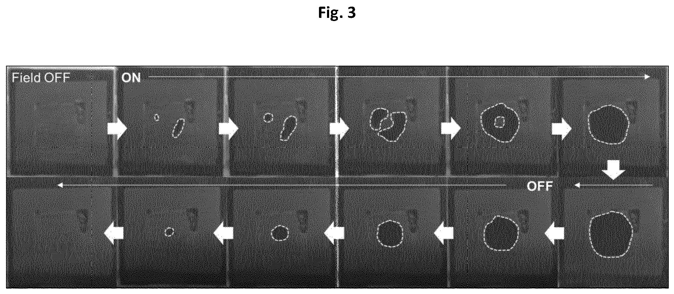

When visually observing the sensor with the naked eye, generation of one or more dark spots on the sensor can be observed, when the HF-AMF was brought into proximity of the sensor, and said spots gradually disappeared within a time period of 5 s upon switching off the high-frequency alternating magnetic field generator coil. A series of photographs illustrating the above-described time period is shown in Figure 3.

As can be seen from Figure 3, the sensor of the present example operates without any external electric power source and gives a visible response in the presence of a HF-AMF that can be observed with the naked eye. Said visible response is reversible and disappears quickly, when no HF-AMF is present in the proximity of the sensor.

## Claims

1. An electric power source-free sensor for detecting high-frequency alternating magnetic fields comprising
a chip which comprises a matrix of thermosensitive liquid crystals which exhibit nematic-isotropic phase transition, and a grid of ferromagnetic wires in thermal contact with the matrix of the thermosensitive liquid crystals,
said sensor further comprising polarizing films which are aligned in an angle of 60° to 120° to each other and which are arranged on a first surface and on a second surface of the chip so as to sandwich the chip.

2. The electric power source-free sensor according to claim 1, wherein the grid of ferromagnetic wires is embedded in the matrix of thermosensitive liquid crystals.

3. The electric power source-free sensor according to claim 1 or 2, wherein the matrix of thermosensitive liquid crystals exhibits a nematic-isotropic phase transition between 0°C and 80 °C.

4. The electric power source-free sensor according to claim 3, wherein the matrix of thermosensitive liquid crystals exhibits a nematic-isotropic phase transition between 30°C and 50 °C.

5. The electric power source-free sensor according to any one of claims 3 or 4, wherein the thermosensitive liquid crystals comprise one or more liquid crystal compounds selected from the group consisting of 4-cyano-4'-pentylbiphenyl, N-(p-methoxybenzylidene)-p'-n-butylaniline and p-pentylphenyl-trans-p'-pentylcyclohexylcarboxylate.

6. The electric power source-free sensor according to claim 5, wherein the thermosensitive liquid crystals comprise 4-cyano-4'-pentylbiphenyl.

7. The electric power source-free sensor according to any one of claims 1 to 6, wherein the ferromagnetic wires comprise a nickel alloy and have a wire diameter of 10 to 200 µm.

8. The electric power source-free sensor according to any one of claims 1 to 7, wherein the ferromagnetic wires are coated with a coating material, preferably hexadecyltrimethylammonium bromide.

9. The electric power source-free sensor according to any one of claims 1 to 8, wherein the polarizing films are flexible linear polymeric polarizing films having a thickness between 0.05 and 1 mm.

10. The electric power source-free sensor according to any one of claims 1 to 9, wherein the polarizing films are aligned in an angle of 85° to 95° to each other.

11. A method for detecting high-frequency alternating magnetic fields, said method comprising a step of detecting a high-frequency alternating magnetic field by using an electric power source-free sensor,
said sensor comprising a chip which comprises a matrix of thermosensitive liquid crystals which exhibit nematic-isotropic phase transition, and a grid of ferromagnetic wires in thermal contact with the matrix of the thermosensitive liquid crystals,
said sensor further comprising polarizing films which are aligned in an angle of 60° to 120° to each other and which are arranged on a first surface and on a second surface of the chip so as to sandwich the chip,
wherein said step of detecting comprises observing a phase transition of said thermosensitive liquid crystals from a nematic phase to an isotropic phase in the presence of a high-frequency alternating magnetic field,
wherein said sensor is not connected to any electrical power source.

12. The method according to claim 11, wherein the thermosensitive liquid crystals comprise one or more liquid crystal compounds selected from the group consisting of 4-cyano-4'-pentylbiphenyl, N-(p-methoxybenzylidene)-p'-n-butylaniline and p-pentylphenyl-trans-p'-pentylcyclohexylcarboxylate.

13. The method according to claim 12, wherein the thermosensitive liquid crystals comprise 4-cyano-4'-pentylbiphenyl.

14. Use of a sensor for detecting a high-frequency alternating magnetic field, wherein said sensor comprises a chip which comprises a matrix of thermosensitive liquid crystals which exhibit nematic-isotropic phase transition, and a grid of ferromagnetic wires in thermal contact with the matrix of the thermosensitive liquid crystals,
said sensor further comprising polarizing films which are aligned in an angle of 60° to 120° to each other and which are arranged on a first surface and on a second surface of the chip so as to sandwich the chip,
wherein said sensor is not connected to any electrical power source.

## Patentansprüche

1. Stromquellenfreier Sensor zum Erfassen hochfrequenter magnetischer Wechselfelder, umfassend:
einen Chip, der eine Matrix von thermosensitiven Flüssigkristallen, die einen nematisch-isotropen Phasenübergang aufweisen, und ein Gitter von ferromagnetischen Drähten in thermischem Kontakt mit der Matrix der thermosensitiven Flüssigkristalle umfasst,
wobei der Sensor des Weiteren Polarisationsfolien, die in einem Winkel von 60° bis 120° zueinander ausgerichtet sind und die auf einer ersten Oberfläche und einer zweiten Oberfläche des Chips so angeordnet sind, dass der Chip sandwichartig umschlossen wird, umfasst.

2. Stromquellenfreier Sensor gemäß Anspruch 1, wobei das Gitter von ferromagnetischen Drähten in der Matrix von thermosensitiven Flüssigkristallen eingebettet ist.

3. Stromquellenfreier Sensor gemäß Anspruch 1 oder Anspruch 2, wobei die Matrix von thermosensitiven Flüssigkristallen einen nematisch-isotropen Phasenübergang zwischen 0 °C und 80 °C aufweist.

4. Stromquellenfreier Sensor gemäß Anspruch 3, wobei die Matrix von thermosensitiven Flüssigkristallen einen nematisch-isotropen Phasenübergang zwischen 30 °C und 50 °C aufweist.

5. Stromquellenfreier Sensor gemäß einem der Ansprüche 3 oder 4, wobei die thermosensitiven Flüssigkristalle eine oder mehrere Flüssigkristallverbindungen umfassen, die aus der Gruppe ausgewählt sind, die aus 4-Cyano-4'-pentylbiphenyl, N-(p-Methoxybenzyliden)-p'-n-butylanilin und p-Pentylphenyl-trans-p'-pentylcyclohexyl-carboxylat besteht.

6. Stromquellenfreier Sensor gemäß Anspruch 5, wobei die thermosensitiven Flüssigkristalle 4-Cyano-4'-pentylbiphenyl umfassen.

7. Stromquellenfreier Sensor gemäß einem der Ansprüche 1 bis 6, wobei die ferromagnetischen Drähte eine Nickellegierung umfassen und einen Drahtdurchmesser von 10 µm bis 200 µm aufweisen.

8. Stromquellenfreier Sensor gemäß einem der Ansprüche 1 bis 7, wobei die ferromagnetischen Drähte mit einem Beschichtungsmaterial, vorzugsweise Hexadecyltrimethylammoniumbromid, beschichtet sind.

9. Stromquellenfreier Sensor gemäß einem der Ansprüche 1 bis 8, wobei die Polarisationsfolien flexible lineare polymere Polarisationsfolien mit einer Dicke zwischen 0,05 mm und 1 mm sind.

10. Stromquellenfreier Sensor gemäß einem der Ansprüche 1 bis 9, wobei die Polarisationsfolien in einem Winkel von 85° bis 95° zueinander ausgerichtet sind.

11. Verfahren zum Erfassen hochfrequenter magnetischer Wechselfelder, wobei das Verfahren einen Schritt des Erfassens eines hochfrequenten magnetischen Wechserfeldes mittels Verwendung eines stromquellenfreien Sensors umfasst,
wobei der Sensor einen Chip umfasst, der eine Matrix von thermosensitiven Flüssigkristallen, die einen nematisch-isotropem Phasenübergang aufweisen, und ein Gitter von ferromagnetischen Drähten in thermischem Kontakt mit der Matrix der thermosensitiven Flüssigkristalle umfasst,
wobei der Sensor des Weiteren Polarisationsfolien, die in einem Winkel von 60° bis 120° zueinander ausgerichtet sind und die auf einer ersten Oberfläche und einer zweiten Oberfläche des Chips so angeordnet sind, dass der Chip sandwichartig umschlossen wird, umfasst.
wobei der Schritt des Erfassens das Beobachten eines Phasenübergangs der thermosensitiven Flüssigkristalle von einer nematischen Phase zu einer isotropen Phase in Gegenwart eines hochfrequenten magnetischen Wechselfeldes umfasst,
wobei der Sensor nicht an eine beliebige Stromquelle angeschlossen ist.

12. Verfahren gemäß Anspruch 11, wobei die thermosensitiven Flüssigkristalle eine oder mehrere Flüssigkristallverbindungen umfassen, die aus der Gruppe ausgewählt sind, die aus 4-Cyano-4'-pentylbiphenyl, N-(p-Methoxybenzyliden)-p'-n-butylanilin und p-Pentylphenyl-trans-p'-pentylcyclohexylcarboxylat besteht.

13. Verfahren gemäß Anspruch 12, wobei die thermosensitiven Flüssigkristalle 4-Cyano-4'-pentylbiphenyl umfassen.

14. Verwendung eines Sensors zum Erfassen eines hochfrequenten magnetischen Wechselfeldes, wobei
der Sensor einen Chip umfasst, der eine Matrix von thermosensitiven Flüssigkristallen, die einen nematisch-isotropem Phasenübergang aufweisen, und ein Gitter von ferromagnetischen Drähten in thermischem Kontakt mit der Matrix der thermosensitiven Flüssigkristalle umfasst,
wobei der Sensor des Weiteren Polarisationsfolien, die in einem Winkel von 60° bis 120° zueinander ausgerichtet sind und die auf einer ersten Oberfläche und einer zweiten Oberfläche des Chips so angeordnet sind, dass der Chip sandwichartig umschlossen wird, umfasst.
wobei der Sensor an nicht an eine beliebige Stromquelle angeschlossen ist.

## Revendications

1. Capteur sans source d'énergie électrique pour détecter les champs magnétiques alternatifs haute fréquence comprenant
une puce qui comprend une matrice de cristaux liquides thermosensibles qui présentent une transition de phase nématique-isotropique et une grille de fils ferromagnétiques en contact thermique avec la matrice des cristaux liquides thermosensibles,
ledit capteur comprenant en outre des films polarisants qui sont alignés dans un angle de 60° à 120° les uns aux autres et qui sont disposés sur une première surface et sur une seconde surface de la puce de manière à prendre en sandwich la puce.

2. Capteur sans source d'énergie électrique selon la revendication 1, dans lequel la grille de fils ferromagnétiques est incluse dans la matrice de cristaux liquides thermosensibles.

3. Capteur sans source d'énergie électrique selon la revendication 1 ou 2, dans lequel la matrice de cristaux liquides thermosensibles présente une transition de phase nématique-isotropique comprise entre 0 °C et 80 °C.

4. Capteur sans source d'énergie électrique selon la revendication 3, dans lequel la matrice de cristaux liquides thermosensibles présente une transition de phase nématique-isotropique comprise entre 30 °C et 50 °C.

5. Capteur sans source d'énergie électrique selon l'une quelconque des revendications 3 ou 4, dans lequel les cristaux liquides thermosensibles comprennent un ou plusieurs composés de cristal liquide choisis dans le groupe constitué par le 4-cyano-4'-pentylbiphényle, la N-(p-méthoxybenzylidène)-p'-n-butylaniline et le p-pentylphényl-trans-p'-pentylcyclohexylcarboxylate.

6. Capteur sans source d'énergie électrique selon la revendication 5, dans lequel les cristaux liquides thermosensibles comprennent le 4-cyano-4'-pentylbiphényle.

7. Capteur sans source d'énergie électrique selon l'une quelconque des revendications 1 à 6, dans lequel les fils ferromagnétiques comprennent un alliage de nickel et ont un diamètre de fil de 10 à 200 µm.

8. Capteur sans source d'énergie électrique selon l'une quelconque des revendications 1 à 7, dans lequel les fils ferromagnétiques sont revêtus avec un matériau de revêtement, de préférence le bromure d'hexadécyltriméthylammonium.

9. Capteur sans source d'énergie électrique selon l'une quelconque des revendications 1 à 8, dans lequel les films polarisants sont des films polarisants polymères linéaires flexibles ayant une épaisseur comprise entre 0,05 et 1 mm.

10. Capteur sans source d'énergie électrique selon l'une quelconque des revendications 1 à 9, dans lequel les films polarisants sont alignés dans un angle de 85° à 95° les uns aux autres.

11. Procédé de détection de champs magnétiques alternatifs haute fréquence, ledit procédé comprenant une étape de détection d'un champ magnétique alternatif haute fréquence en utilisant un capteur sans source d'énergie électrique,
ledit capteur comprenant une puce qui comprend une matrice de cristaux liquides thermosensibles qui présentent une transition de phase nématique-isotropique et une grille de fils ferromagnétiques en contact thermique avec la matrice des cristaux liquides thermosensibles,
ledit capteur comprenant en outre des films polarisants qui sont alignés dans un angle de 60° à 120° les uns aux autres et qui sont disposés sur une première surface et sur une seconde surface de la puce de manière à prendre en sandwich la puce,
ladite étape de détection comprenant l'observation d'une transition de phase desdits cristaux liquides thermosensibles d'une phase nématique à une phase isotropique en présence d'un champ magnétique alternatif haute fréquence,
ledit capteur n'étant connecté à aucune source d'énergie électrique.

12. Procédé selon la revendication 11, dans lequel les cristaux liquides thermosensibles comprennent un ou plusieurs composés de cristal liquide choisis dans le groupe constitué par le 4-cyano-4'-pentylbiphényle, la N-(p-méthoxybenzylidène)-p'-n-butylaniline et le p-pentylphényl-trans-p'-pentylcyclohexylcarboxylate.

13. Procédé selon la revendication 12, dans lequel les cristaux liquides thermosensibles comprennent le 4-cyano-4'-pentylbiphényle.

14. Utilisation d'un capteur pour détecter un champ magnétique alternatif haute fréquence, dans laquelle ledit capteur comprend une puce qui comprend une matrice de cristaux liquides thermosensibles qui présentent une transition de phase nématique-isotropique et une grille de fils ferromagnétiques en contact thermique avec la matrice de cristaux liquides thermosensibles,
ledit capteur comprenant en outre des films polarisants qui sont alignés dans un angle de 60° à 120° les uns aux autres et qui sont disposés sur une première surface et sur une seconde surface de la puce de manière à prendre en sandwich la puce,
ledit capteur n'étant connecté à aucune source d'énergie électrique.
